Europäisches Patentamt

European Patent Office

Office européen des brevets

(19)

(11) Publication number: 0 451 646 A2

# EUROPEAN PATENT APPLICATION

(21) Application number: 91105044.1

(22) Date of filing: 28.03.91

(51) Int. Cl.5: G06F 11/10

(30) Priority: 06.04.90 IT 1995890

(43) Date of publication of application:
16.10.91 Bulletin 91/42

(84) Designated Contracting States:
AT BE CH DE ES FR GB IT LI NL SE

(71) Applicant: ALCATEL FACE STANDARD S.p.A.
Viale L. Bodio 33/39
I-20158 Milano(IT)

(72) Inventor: Recchia, Mauro
Via Padova 96
Roma(IT)
Inventor: Puglia, Bilvestro
Via Rumenia 28/A
Pomezia(IT)

(74) Representative: Pohl, Heribert, Dipl.-Ing et al
Standard Elektrik Lorenz AG Patent- und
Lizenzwesen Postfach 30 09 29
W-7000 Stuttgart 30(DE)

(54) Circuit device for correction of double errors and detection of triple errors.

(57) A circuit device is disclosed for correction of double errors and detection of triple errors not based on external and large memories, working according to an algorithm and so realizable as an IC.

The circuit device (1) is devided into a transmitting block (2) having two separate coding sections (6, 8) connected in series, one (6) for double error correction and one (8) for triple-error detection, a receiving block (3) having two corresponding decoding sections (14, 15; 16) and testing means (5, 10, 11), selectionable and programable from outside devices, for testing the whole circuit device during both operation and non-operation conditions.

Tav. I

Fig. 1

The present invention is concerned with a circuit device for correction of double errors and detection of triple errors.

As known, in the field of devices for the error correction in data transmission are several commercial embodiments which perform the error detection and correction function by using of so-called Hamming codes, which are able to correct single errors and to detect the double ones.

On the contrary, for performing the correction of double errors and detection of triple errors, according the present state of the art, there are solutions based upon very extended external memories.

Due to their complexity, such solutions are not very reliable, having not a high level of integration, being power consuming and expensive.

The main object of the present invention is to solve the aforementioned problem and therefore to eliminate the abovementioned drawbacks by realizing a circuit device for correction of double errors and detection of triple errors which is able to perform coding, error correction and detection functions with a considerable reduction in power consumption, according an integrable structure, thus providing a higher reliability while avoiding the use of burdensome external memories for decoding.

This and other objects are attained through a circuit device as set forth in claim 1. Further advantageous features of the invention are defined in the subclaims and will become apparent from the following description.

The basic idea of the invention is to provide a transmitting block having two separate coding sections connected in series, one for double-error correction and one for triple error detection, and a receiving block having two corresponding decoding sections, and testing means for testing the working of the circuit device. Both, coding and decoding sections work in an algorithmic way.

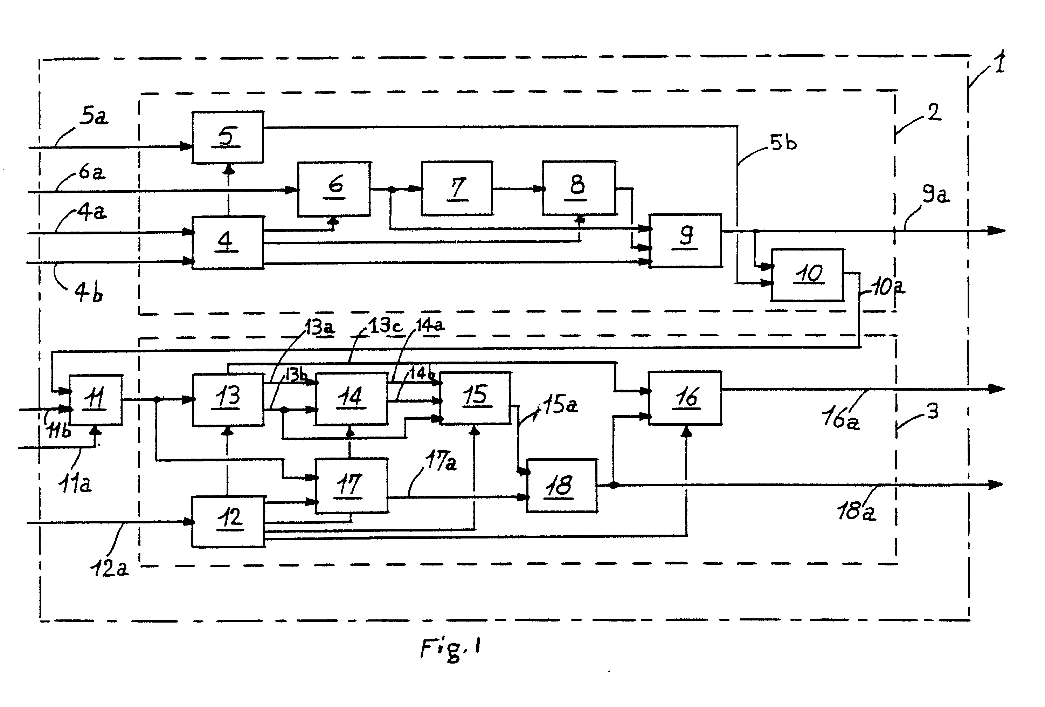

The invention will become more apparent from the following description of an embodiment thereof taken in conjunction with the accompanying drawing, showing the circuit device.

First of all, it has to be specified that BCH means Binary Code Hamming, which is the decoding form according to Hamming binary logic theory to which reference has to be made for details.

With reference to such figure, 1 stands for the circuit device whereon are a transmission block 2 and a receive block 3. Within transmission block 2 is a timing circuitry 4 for generating the control signals for all the circuit sections present in block 2, and a circuitry 5 for generating desired errors at the output of a section 9, which is a multiplexer.

Numeral reference 6 indicates a coding circuitry according BCH (127, 113) code, which allows the coding of a serial data stream in one hundred thirteen bits received at an input or pin 6a.

Numeral reference 7 indicates a circuitry which allows a parity generation, whereas 8 stands for another circuitry for coding the parity check signal from section 7.

Signal 4a starts the operation of the relative timing section 4 so as to allow the coding of the serial data stream transmitted via the input 6a.

Through input 4b it is possible to select the type of parity check within the timer 4 as will be explained more in detail in the following.

By means of an Exclusive OR 10 it is possible to invert the output bits in order to provide an output 10a according to what expected, with desired number and position of error bits.

Reference 9a indicates the normal output, i.e., the corresponding output of the transmission block 2.

The output 10a goes to section 13 through a multiplexer 11. At the input of multiplexer 11 is also input 11b, which is the normal input of the receive block 3. Through a select signal 11a it is possible to decide which of the two signals 10a und 11b send to section 13.

From such multiplexer 11, the signal is then transmitted to a section 13 which substantially calculates the syndrome on the first, more significant, one hundred twenty seven bits received and at whose output power sums 13a and 13b, which result from the processing of the received data stream, are generated.

Inside block 3 is a timing section 12 similar to section 4 of receive block 2.

Also timing section 12 receives in turn a start pin 12a which activates the relative circuitry.

By means of a double-error detection section 14 the eventual errors present in the received code are detected and thus sent, through relative addressing by the signals 14a and 14b, to another section 15 which is a double-error correction section.

Such section generates a correction signal 15a in a proper position for a maximum of two errors present in the data code.

By means of a section 17 it is possible to delay data entering block 3 and such section 17 presents at the output a signal 17a which will enter one of the inputs of an Exclusive OR 18 and will then add to the correction signal 15a from section 15.

The output from section 18 will enter an input of a last section 16, representing a circuitry which detects the presence of triple errors.

Such triple-error detection section 16 will then generate an error signal 16a at the output, if any coding irregularity in the data stream has been detected.

The normal output receive block 3 is signal 18a.

From the above structual description it is apparent that the complexity of the circuit device is such that it could be integrated, furthermore its parallel structure permits to achive good speed results thus enabling the use of "slow" technologies such as Gate Array CMOS.

This leads to lower power consumption, higher operating speed, greater reliability and lower costs.

After a description in a mainly structural meaning, the operating of the device according to the present invention wil be described in detail.

The circuit device is designated as FEC (Forward Error Correction) i.e., errcr correction in successive steps.

The device makes use of error correction code of BCH (127, 113) type. This code has an Hamming distance equal to 5, i.e., the difference between any two codes is not less than 5 bis, therefore is able to correct all single and double errors on the group of the one hundred twenty seven bits; for this purpose a field of 14 bits is added to the 113 bits.

For triple errors detection a further field has been used. Such code has been extended with a global parity bit so that a BCH extented (128, 113) code with a minimum distance equal to 6 is obtained. In this way it is possible to detect triple errors. This further parity bit has to be protected against double errors and so it is coded, thus obtaining a 5 bit string. This further field is added to the 127 bits resulting in a BCH extended (132, 113) code.

In order to realize a decoder which does not require external memories, the BCH (127, 113) block and the global parity bit are decoded separately by using the two coding sections indicated in figure by 6 and 8, as well as by parity generator 7.

In the transmission block, a first coding is realized on the block of one hundred thirteen symbols (i.e. bits) which are to be transmitted according to a polynomial generating the BCH (127, 113) code which, from an algebraic viewpoint, may be represented as:

$$1 + x + x^2 + x^4 + x^5 + x^6 + x^8 + x^9 + x^{14}.$$

To the one hundred twenty seven bits so obtained a parity field is added calculated on the one hundred seven eight bits and coded according to code (5, 1). A block code (132, 113) is so obtained and then transmitted.

The start signal is given through the input 4 which serves for activating all the circuitry.

The correction of single and double errors is performed by the circuitries 13, 14 and 15, whereas the detection of triple errors is performed by section 16.

In the receive block 3 the 132 bits are sent to section 13, but only the 113 original bits are sent to section 17 for delaying and synchronization purpose.

Inside section 13 the parity field is decoded and the syndrome is generated. The parity bit and the syndrome together form the first redundancy 13c, and this first redundancy is sent to section 16.

The 113 corrected bits outputted form section 18 are sent to section 16 where first are codified into 127 bits, second a parity bit is computed on such 127 bits, third the computed 14 bits are extracted from such 127 bits and last a second redundancy, comprising the parity bit and the 14 bits, is obtained.

The two redundancies are compared in section 16 and, if different, the presence of three errors, obviously not corrected, is detected in the received one hundred twenty seven bits. Then an error signal 16a will be present at the output of section 16 which can be read and detected.

More in detail it can be noted that by section 6 of transmission block 2 the coding of a serial data stream in one hundred thirteen bits received at its input, represented by pin 6a, is performed.

The activation of said sequence is performed via pin 4a which activates the timer 4.

Coding is performed by generating 14 bits, called as above redundancy bits to be added to the already existent one hundred thirteen bits so as to form a data stream or block of one hundred twenty seven bits coded according to BCH (127, 113) cyclic Hamming code.

A parity check on said one hundred twenty seven bits is then carried out by section 7, generating a bit equal to 1 if the number of ones therein contained is odd, or equal to 0 if such number is even.

Finally, the coding of the parity check signal from section 7 is realized by section 8.

Such coding may be set up externally so as to obtain a block code (5, 1), a data stream is thus generated which will be added in the multiplexer 9, to the end in the data stream of one hundred twenty seven bits form coder 6, thus providing a serial data stream of one hundred thirty two bitds at the output pin 9a.

The timer 4, as well as the one 12 of receive block 3, generates all the control signals for the management of the various circuitries present in block 2 and 3. Moreover, it is possible to choose the type of parity control through input pin 4b.

Section 5 is an error generator which under circuit test conditions generates an error data stream 5b to be added to the data flow outgoing from the multiplexer section 9.

At its input are control signals from a generic external microprocessor connected to device 1 via the input 5a, on which two address lines are also connected. The external microprocessor, through writing on special internal registers not shwon in figure, can program the location of three errors at most in the 132 bits.

In summary at the output there are, in positions programmed by such microprocessor, one or more errors introduced in the serial data flow from multiplexer 9. Such errors are generated by realizing bit inversions through the exclusive OR 10 in the desired positions on data flow. Such data stream, containing errors, is sent to the input of receive block 3 on the pin relative to multiplexer 11 where global correction and detection of such errors shall occur.

Naturally the external microprocessor has the chance to check wether the 113 bits sent to the transmitting block 2 and the 113 bits outputted by the receive block 3 are identical. Using different numbers and positions of errors the microprocessor can make a test of the circuit device during both operation and non-operation conditions.

Relatively to receive block 3, we can add that the syndrome in the first 127 received bits is calculated in block 13; the start is initiated at the relative input pin of multiplexer 11 via pin 12 and relative timing circuitry 12.

Such calculation is obtained by determining the power sums indicated in figure by 13a and 13b.

The two inputs inside block 14 allow the calculation of eventual errors present in the received code, the eventual detection of position and then the transmission of the relative result to correction block 15.

The addressing of the error eventually detected is received in such block and correction signals are generated in an appropriate position for at most two errors present in the data code.

Block 17 which is a data buffer, i.e., a data memory, is used for delaying input data in receive block 3 so taht this will be in phase coincidence with correction signal 15a.

A signal 17a will be present at the output and will enter the exclusive OR 18, and at the other input of the same exclusive OR 18 is a correction signal 15a which will perform error correction by adding itself to 17a.

By block 16 it is possible to detect the presence of three errors in the data code; in such event no correction occurs but an error signal 16a is present at the output of device 1 and indicates thus a useful information to the external microprocessor for an eventual retransmission of the previously transmitted data stream.

All the circuitries described in blocks 2 and 3 are logic circuitries. The error correction is a FEC type correction.

Obviously parametric and circuit variants may be made without departing in any way from the spirit of the present invention.

## Claims

1. Circuit device (1) for correction of double errors and detection of triple errors,
   **characterized** in that it comprises a transmission block (2) which allow the coding of an input data stream (6a) to be transmitted, and a receive block (3) which allows the correction of double errors and the detection of triple errors present in the received data stream (11b), said transmission block and said receive block having means (5, 10, 11) for testing the correct working of said circuit device (1).

2. Circuit device according to claim 1, charaterized in that said transmission block (2) comprises:
   - a first coder (6) for reading a first string of N bits and generating a second string of M bits according to a code that permits detection and correction of double errors, said second string consisting of said first string followed by a third string,
   - a parity bit generator (7) for reading said second string and generating a parity bit
   - a second coder (8) for reading said parity bit and generating a forth string, according to a code that permits detection and correction of double errors, and
   - a first multiplexer (9) for reading said second string and said forth string and sequentially transmitting them.

3. Circuit device according to claim 2, characterized in that said receive block (3) comprises:
   - a syndrome generator (13) reading said received data stream (11b), decoding said forth string into said parity bit, calculating the syndrome in the form of a first (13a) and a second (13b) power sums, and generating a first redundancy signal (13c) composed of said parity bit and said syndrome,
   - a double-error detection section (14) for reading said power sums (13a, 13b) and generating relative addresses of errors (14a, 14b),
   - a double-error correction section (15) for reading said relative addresses (14a, 14b) and said second power sum (13b) and generating a correction signal (15a),
   - delay means (17) for reading said received data stream and generating a delaied data stream (17a),

- a first Ex-OR (18) for reading said correction signal (15a) and said delaied data stream (17a) and generating a corrected data stream (18a), and

- a triple-error detection section (16) for reading said first redundancy signal (13c) and said corrected data stream (18a), computing said second and third strings, calculating a parity bit on said second string, associating said parity bit and said third string into a second redundancy signal, comparing said two redundancy signals and generating an error signal (16a) if said two redundancy signals are different.

4. Circuit device according to claim 1, characterized in that said testing means comprises:

- an error generator (5) activated on demand and programable, relatively to the number and position of errors, through control signals (5a), for generating an error data stream (5b),

- a second Ex-OR (10) for reading the output of the transmission block (9a) and said error data stream (5b), adding them and generating a test data stream (10a), and,

- a second multiplexer (11) for reading said test data stream (10a) and said received data stream (11b) and selecting, in relation to a select signal (11a), which of said data streams forwards to the input of said receive block (3).

5. Method for testing the circuit device according to claim 4, characterized in that it comprises the steps of:

- programing said error generator (5), through said control signals (5a),

- selecting said test data stream (10a), through said select signal (11a), and

- checking the identity of said input data stream (6a) and of said corrected data stream (18a).

Fig. 1

EP 0 451 646 A2